# EUROPEAN PATENT SPECIFICATION

(11) **EP 4 344 047 B1**
(45) Date of publication and mention of the grant of the patent: **03.09.2025**
(21) Application number: 23198831.2
(22) Date of filing: 21.09.2023
(51) Int. Cl.: H02N 2/18, H10N 30/30, E01F 11/00

(54) **SUSTAINABLE POWER GENERATION SYSTEMS**
NACHHALTIGE STROMERZEUGUNGSSYSTEME
SYSTÈMES DE PRODUCTION D'ÉNERGIE DURABLE

(30) Priority: 23.09.2022 IT 202200019569
(43) Date of publication of application: 27.03.2024
(73) Proprietor: Fioravanti, Leonardo, 10024 Moncalieri (TO) (IT)
(72) Inventor: FIORAVANTI, Leonardo, 10024 Moncalieri (Torino) (IT)
(74) Representative: Fioravanti, Corrado

(56) References cited:
- JP-A- 2011 250 521
- KR-A- 20160 015 810
- US-A1- 2005 127 677
- US-A1- 2005 258 717
- US-A1- 2009 195 124
- US-A1- 2012 169 064

## Description

The present invention relates to systems for producing sustainable electric power. The invention is applicable in various fields to exploit the mechanical energy of moving masses, producing electric power.

### Background art

When it comes to energy resources, the question of sustainability is becoming increasingly topical. It is also important to consider how resources can be used in the long term. Some resources will practically never run out: these are the so-called renewable resources. Renewable resources produce clean energy, which means less pollution and greenhouse gas emissions that contribute to climate change.

Dynamic Wireless Power Transfer (DWPT) charging of electric cars has recently been proposed. This technology, based on dynamic induction, allows electric vehicles to recharge their batteries simply by driving along a stretch of motorway. With DWPT, electric vehicles can be recharged in wireless mode by travelling on wired lanes thanks to a system of loops placed under the asphalt. This technology is adaptable to vehicles equipped with a special receiver module that transfers incoming energy from the road infrastructure to the battery. One of the benefits of this technology is the reduction of the capacity (and thus the mass) of the batteries and the time to recharge them. One of the goals of DWPT technology is to avoid vehicles having to carry large and heavy batteries, the production and disposal of which is problematic.

Patent GB 2498215 A discloses a road pavement comprising a layer of intermediate material (interlayer) and a plurality of piezoelectric elements arranged therein, on or against the layer of intermediate material. Changes in pressure on the pavement, for example by a vehicle, generate electricity through the plurality of piezoelectric elements. A transmission line transmits the electric energy generated by the plurality of piezoelectric elements to an output.

US 2012/169064 A1 discloses methods and systems for harvesting vibrational energy from vehicles, as well as methods for locating vibrational energy on a vehicle. A vibrational energy harvester is coupled to a maximum vibrational displacement node of a structural element of a vehicle. Vibrational energy harvesters may be piezoelectric devices. The publication proposes methods for identifying appropriate structural elements for vibrational energy harvesting. Circuitry that converts electrical signals generated by vibrational energy harvesting devices from high voltage input alternating current to low voltage output direct current is provided, as well as circuitry for storing or utilizing the harvested electrical energy.

JP 2011 250521 A discloses power generation panels designed to convert an external force by walking of a pedestrian into electricity by way of a piezoelectric device, enabling the pedestrian to walk. The system comprises a housing which displaces by receiving the external force by the walking. A piezoelectric device disposed in the housing deforms according to a displacement of the housing to generate power. A display outputs prescribed information to the pedestrian using the electric power generated by the piezoelectric device.

KR 2016 0015810 A discloses a wireless power transmission device comprising: an energy harvesting unit for converting idle energy generated in an automotive wheel into electric energy; a transmission source coil which is wound outside a rim of the automotive wheel, and transmits the electric energy received by the energy harvesting unit through magnetic induction; and a transmission resonance coil which is wound outside the rim of the automotive wheel, and wirelessly transmits the electric energy induced in the transmission source coil by resonating the electric energy through the magnetic resonance. A part of the idle energy generated by the wheel is transmitted to a device that may use it.

US 2005/ 127677 A1 discloses a process for generating electricity from vehicular traffic. The process includes distributing a plurality of piezoelectric elements no higher than an adjacent surface of a roadway. Electric current is generated as traffic passes over the roadway, and the electric current conducted away from the piezoelectric elements to provide the electrical current for consumption.

US 2005/258717 A1 discloses the use of piezoelectric generators for recapturing expelled kinetic energy that would otherwise be wasted. Piezoelectric generators may be placed in shoes, clothing, tires, roads, and sidewalks in order to recapture the energy expelled in everyday human activities (e.g., walking, moving, and driving).

### Summary of the invention

It is an object of the present invention to exploit hitherto unused mechanical energy from moving masses, and to transform at least part of this mechanical energy into electric power. A particular object of the invention is to generate clean energy with zero environmental and aesthetic impact.

The aforementioned and other objects and advantages are achieved, according to a first aspect of the present invention, by a system for generating electric current having the features set forth in claim 1. Preferred embodiments of the invention are set forth in the dependent claims.

In summary, the invention provides a system for generating electric current comprising a carriageway having:
at least one power-generating lane section for the generation of electric current, this lane having a road pavement that incorporates a plurality of electric current generating panels each comprising a plurality of piezoelectric elements, which are compressible downwards to be compressed by a vehicle travelling on this power-generating lane section, and
at least one dynamic induction charging lane section, with power transmission coils suitable for electrically charging a vehicle in transit on said section of dynamic induction charging lane, where the power transmission coils are electrically connected to dynamic induction charging coils of the dynamic induction charging lane section.

### Brief description of the drawings

In order that the present invention may be well understood, a few preferred forms thereof will now be described, by way of example, with reference to the accompanying drawings, in which:
FIG. 1 is a schematic perspective view of a carriageway including an electric power generation lane and an induction charging lane;
FIG. 2 is a schematic side view of a vessel bearing on its bow an electric power generation system according to an example that is not part of the present invention;
FIGS. 3 and 4 are a schematic side and plan view, respectively, of a bow of the vessel depicted in Figure 2 including a power generation system that is not part of the invention;
FIGS. 5 and 6 are a schematic side and plan view, respectively, of a bow comprising a power generation system of a vessel according to an example that is not part of the present invention;
FIG. 7 is a schematic side view of an aircraft provided with an electric power generation system according to an example that is not part of the present invention; and
FIG. 8 is a schematic side view of a cascade having at its base an electric power generation system according to an example that is not part of the present invention.

### Detailed description

A system 10 for generating electric current comprises at least one electric current generating panel 12 and at least one electricity-using or electricity-storing device 16, electrically connected to said electric current generating panel 12. Such a system 10 may be implemented in different embodiments.

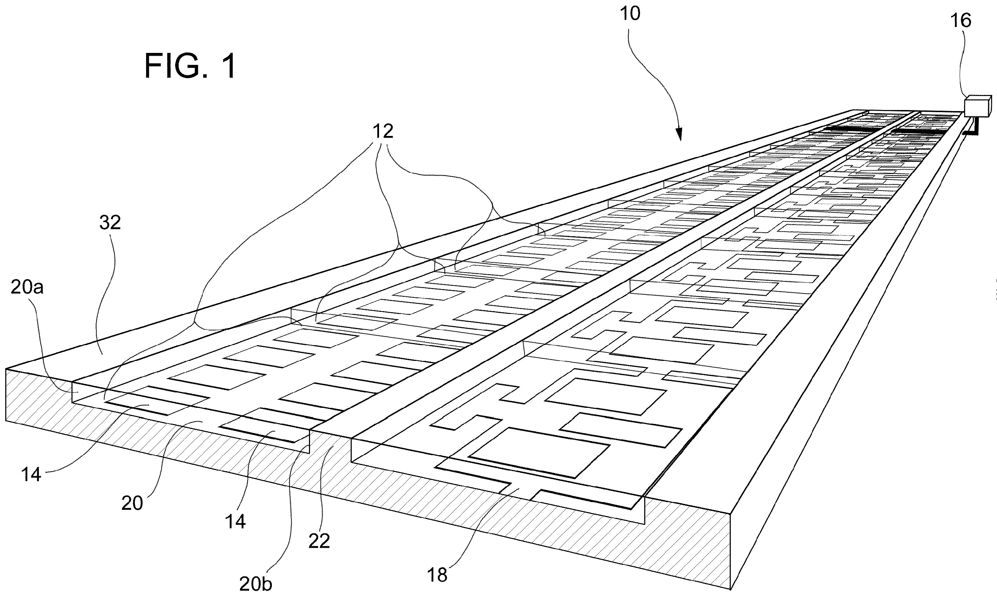

Referring initially to Figure 1, a carriageway according to a first exemplary embodiment of the present invention is designated in its entirety at 22. The carriageway 22 comprises a dynamic induction charging lane 18 and a power-generating lane 20, alongside the dynamic induction charging lane 18.

The lane 18, for dynamic induction charging, is to be considered known *per se.* Accordingly, only those elements of specific relevance and interest for implementing the present invention will be described in detail in the following description. For the implementation of parts and elements not illustrated in detail, reference may therefore be made to any known dynamic induction charging lane solution. Suffice it to recall herein that a dynamic induction charging lane 18 usually comprises a system of power transmission coils incorporated in the road pavement, typically under the road surface, and operatively induction-coupled with an electric power receiving module mounted on board an electric vehicle. The electric power receiving module comprises at least one electric power receiving coil and an associated receiving circuit mounted on board the same vehicle and arranged to transfer the incoming electric power into an on-board electrical storage unit. Thanks to the DWPT charging lane, electric vehicles are recharged electrically.

According to one aspect of the present invention, power transmission coils incorporated in the lane 18 are connected to and electrically powered by panels 12 of piezoelectric power generation elements 14 incorporated in the pavement of the lane 20.

Each generator panel 12 comprises a plurality of piezoelectric current-generating elements 14, which are oriented in a given direction, and arranged to be compressed in said given direction by the passage of a vehicle whose wheels rolling on the panel or on an element integral therewith, by the effect of gravity cause compression of the piezoelectric elements and generate a current which is conveyed to a user device 16. The user device 16 may alternatively be represented either by the transmission coils incorporated in the road pavement of the charging lane, or by one or more current accumulators electrically connected to one or more of said transmission coils.

As known, the deformation to which piezoelectric generating elements 14 are subjected generates a potential difference that generates an electric current between opposite ends of each piezoelectric element.

According to the embodiment shown in Figure 1, for road applications, the piezoelectric elements 14 are oriented and arranged to be compressed in a direction perpendicular or substantially perpendicular to a flat surface in which the panel 12 extends, intended to be arranged in a parallel plane below the road surface 32.

Preferably, the piezoelectric elements 14 are arranged towards or adjacent to side ends 20a and 20b of the power-generating lane 20 in such a way that they are located where the wheels of a vehicle travelling on the lane 20 pass.

Advantageously, the piezoelectric elements 14 may have an elongated shape along a transverse direction with respect to the direction of travel of the vehicles, i.e. they can extend from the side ends 20a and 20b of the lane 20 towards a mid-line of the same lane 20. Such an arrangement of the piezoelectric elements 14 ensures the passage of the wheels of the vehicles over the piezoelectric elements 14 in the case of the passage of vehicles with different dimensions, i.e. vehicles having different widths, and/or in the case of small lateral displacements of the vehicles travelling on the power generating lane.

Therefore, it is the electric vehicles themselves which, simply by travelling along a length of the power-generating lane 20, generate electric power due to their own gravitational force which, through the wheels of the vehicle, compresses and activates the piezoelectric elements 14, resulting in the generation of electric current which is used to recharge, at least partially, the electric accumulators on board the same vehicle or other electric vehicles travelling on the dynamic induction charging lane 18. Alternatively, the electric current generated by the piezoelectric elements 14 may recharge the stationary electric accumulators 16 arranged along the carriageway.

According to some embodiments, the dynamic induction charging lane 18 and the power-generating lane 20 are laterally or transversely arranged side-by-side for some carriageway sections 22 (Figure 1), so that vehicles travelling on the dynamic induction charging lane 18 can move sideways and change lanes, moving onto the power-generating lane 20 and then return to the dynamic induction charging lane 18 to recharge.

According to an alternative embodiment, sections of dynamic induction charging lane 18 may be interrupted by and alternated with sections of power-generating lane 20, interspersed and aligned with stretches of dynamic induction charging lane 18. In this way, vehicles do not need to change lanes to generate electricity on a power-generating lane 20 and then return to the dynamic induction charging lane 18 to recharge.

Advantageously, the provision of an electricity-generating lane allows electric vehicles travelling on this lane to be recharged, taking advantage of DWPT technology even in the absence of an electrical network connection for energizing the road pavement.

The compression of piezoelectric elements 14 not located in the immediate vicinity of the vehicle wheels can also be performed by means of vertically movable horizontal connecting beams, e.g. extended in a direction transverse to the direction of vehicle travel, which are configured to lower when a vehicle wheel passes over a part of them, and thus also cause the compression of piezoelectric elements not immediately below the area of a vehicle wheel passage.

In the following, other examples will now be described that are based, similarly to the gravity-driven operation that governs the above-described embodiments, on the principle of exploiting, for the generation of electric power, various forces that are produced by the movement of a mass, in particular, but not exclusively, by the movement of the mass of a vehicle.

According to some examples, exploited are systems of forces that are produced by the movement of a vehicle that moves forward and involves the displacement of a considerable mass, and/or moves at a very high speed, and in both cases impacts and exchanges considerable reaction forces with the fluid medium it passes through.

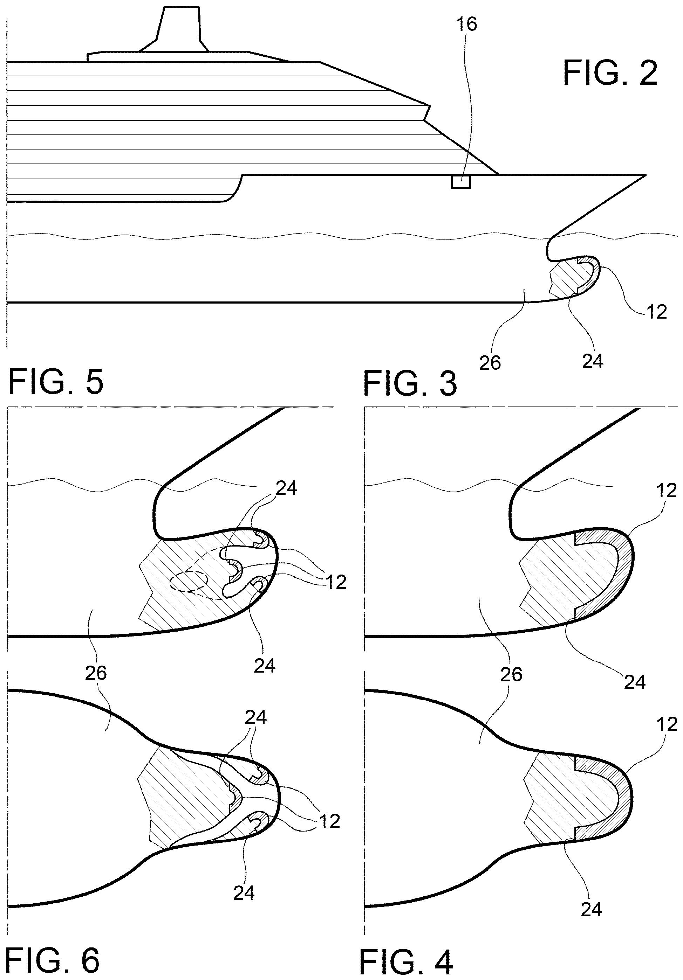

In accordance with the example that is not part of the invention shown in Figures 2-6, the forces developed on the hull of a vessel at the interface between a front, submerged surface 24 of the hull 26 when the vessel is in motion are exploited. One or more generator panels 12, each comprising a plurality of piezoelectric current-generating elements 14 (Figure 1), may be fitted on an outer, submerged front surface 24 of the hull 26, and thus below the waterline. The generator panels 12 are oriented facing the direction of advancement of the vessel. In this way, the piezoelectric elements 14 are repeatedly compressed in said direction by forces of continuously varying intensity due to the continuous changes and oscillations in the trim of the boat, with consequent and corresponding changes in the pressure determined by the resistance that the water opposes to the advancement of the vessel.

The electric current generated by the compression of piezoelectric elements 14 is used to recharge electrical devices 16 or accumulators placed on board the vessel.

The piezoelectric element panels 12 may be shaped to fit the profile or shape of the outer 24 submerged surface of the hull on which they are installed, typically a surface in the bow area. For example, one or more panels 12 of piezoelectric elements may be applied to the bulb of a ship's hull (Figures 3-4). In order to optimise the exploitation of dynamic forces, piezoelectric panels may be located, for example, in concave areas (Figures 5-6) of the bulb, facing forward, suitable to impact against the flow of water entering a hydrodynamic channel into which water is conveyed.

Due to the surface extension of the panels 12 of piezoelectric elements 14, and the tonnage of a cruise ship, aircraft carrier, container ship, and LNG carrier, which can be hundreds of thousands of tonnes, the movement of the advancing vessel causes high forces of continuously varying intensity. These forces, acting on a multitude of piezoelectric elements 14 arranged on one or more impacting external surfaces 24, generate an electric current that is transmitted to an electric accumulator mounted on board the vessel.

In the case of less heavy vessels, but with high sea speeds, such as motor yachts and speedboats, panels 12 of piezoelectric elements 14 arranged on external surfaces 24 impacting a mass of water may form power generating hulls.

The choice of placing panels 12 of piezoelectric elements 14 on external surfaces 24 facing perpendicular to the forward direction of the vessel is a preferred, but not essential choice from a performance and force intensity variation point of view. Panels 12 of piezoelectric elements 14 may also be arranged on submerged surfaces inclined with respect to the direction of advancement of the vessel.

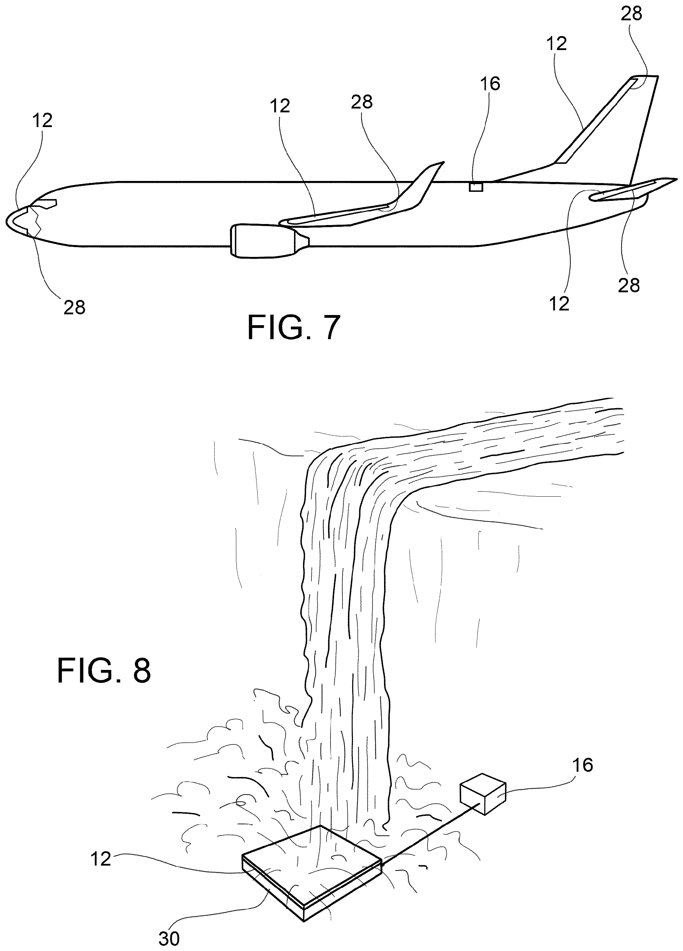

According to the example illustrated in Figure 7, the forces developed on an external surface 28 of an aircraft are utilised, in particular (but not exclusively) on the front surface of the nacelle, and/or on the leading edges of wings and stabilisers. In this example, with lower masses than on a ship, but with much higher speeds than on a vessel, the movement of an aircraft creates high and continuously varying fluctuating forces during the flight.

One or more generator panels 12 each comprising a plurality of current-generating piezoelectric elements 14 may be applied to front facing surfaces 28 of the aircraft, oriented facing the forward direction of the aircraft and impacting the air during a flight. As with the examples described above, the piezoelectric elements 14 are repeatedly compressed in said direction due to forces of continuously varying intensity as a result of the continuous changes and oscillations in the attitude of the aircraft and the density of the air, with consequent and corresponding changes in the pressure determined by the resistance that the air opposes to the advancement. The electric current generated by the compression of the piezoelectric elements 14 is used to recharge electrical devices 16 or accumulators on board the aircraft.

The panels 12 of piezoelectric elements 14 may be shaped to fit the profile or shape of the front surface of the nacelle or the leading edges of wings or empennages where the panels are installed.

According to a further example, which is not part of the present invention, shown in Figure 8, variable forces developed in areas where a waterfall of a watercourse impacts against a supporting surface 30 are exploited. One or more panels 12 generators each comprising a plurality of piezoelectric current generating elements 14 may be applied to said supporting surface 30 (which may be, for example, a rock). Preferably, the panels 12 are oriented facing upwards, opposite the direction in which the waterfall flows. As with the preceding examples, the piezoelectric elements 14 are repeatedly compressed in said direction due to the continuously varying intensity forces of the falling and impacting water.

Without prejudice to the principle of the invention, the details of implementation and embodiments may be varied from what is described and illustrated, without departing from the claims.

## Claims

1. A system (10) for generating electric current, comprising a carriageway (22) with:
at least one power-generating lane section (20) having a road pavement which incorporates a plurality of electric current generator panels (12) comprising a plurality of piezoelectric elements (14) compressible and oriented facing a given direction, configured to be compressed and consequently generating an electric current due to the movement of a vehicle, **characterized by**
at least one lane section (18) for dynamic wireless power transfer with power transmission coils (16) electrically connected to said panels (12) of power-generating piezoelectric elements (14) and being configured to electrically recharge an electric vehicle transiting on the lane section (18) for dynamic wireless power transfer.

2. A system (10) for electric current generation according to claim 1, wherein the lane section (18) for dynamic wireless power transfer is parallel to and alongside the power-generating lane section (20) having the electric current generator panels (12).

3. A system (10) for electric current generation according to claim 1, wherein the lane sections (18) for dynamic wireless power transfer are interspersed with and longitudinally aligned to power-generating lane sections (20) having the electric current generator panels (12).

4. A system (10) for electric current generation according to any one of claims 1 to 3, wherein at least some of the piezoelectric elements (14) are arranged towards lateral ends (20a and 20b) of the lane section (20) having the electric current generator panels (12).

5. A system (10) for electric current generation according to any one of the preceding claims, wherein at least some of the piezoelectric elements (14) have a shape that is elongate in a direction transversal with respect to the direction of advancement of the vehicles.

6. A system (10) for electric current generation according to claims 4 and 5, wherein at least some of the piezoelectric elements (14) extend transversely from one of the two opposite lateral ends (20a or 20b) of the lane section (20) with power generating panels towards a mid-line of the same lane section.

## Patentansprüche

1. System (10) zur Stromerzeugung, umfassend eine Fahrbahn (22) mit:
mindestens einem stromerzeugenden Fahrspurbereich (20) aufweisend einen Straßenbelag, der eine Vielzahl von Stromgeneratorplatten (12) umfasst, die eine Vielzahl komprimierbarer piezoelektrischer Elemente (14) enthalten, die in eine bestimmte Richtung ausgerichtet sind und dazu konfiguriert sind, durch die Bewegung eines Fahrzeugs komprimiert zu werden und infolgedessen Strom zu erzeugen, **dadurch gekennzeichnet, dass**
mindestens ein Fahrspurbereich (18) für die dynamische drahtlose Stromübertragung mit Stromübertragungsspulen (16) versehen ist, die elektrisch mit den Platten (12) der stromerzeugenden piezoelektrischen Elemente (14) verbunden sind und dazu konfiguriert sind, ein Elektrofahrzeug, das den Fahrspurbereich (18) für die dynamische drahtlose Stromübertragung durchfährt, elektrisch wiederaufzuladen.

2. System (10) zur Stromerzeugung nach Anspruch 1, wobei sich der Fahrspurbereich (18) für die dynamische drahtlose Stromübertragung parallel und angrenzend an dem stromerzeugenden Fahrspurbereich (20) aufweisend die Stromgeneratorplatten (12) befindet.

3. System (10) zur Stromerzeugung nach Anspruch 1, wobei die Fahrspurbereiche (18) für die dynamische drahtlose Stromübertragung mit den stromerzeugenden Fahrspurbereichen (20) aufweisend die Stromgeneratorplatten (12) vermischt sind und längs denselben ausgerichtet sind.

4. System (10) zur Stromerzeugung nach einem der Ansprüche 1 bis 3, wobei mindestens einige der piezoelektrischen Elemente (14) zu den seitlichen Enden (20a und 20b) des Fahrspurbereichs (20) aufweisend die Stromgeneratorplatten (12) angeordnet sind.

5. System (10) zur Stromerzeugung nach einem der vorhergehenden Ansprüche, wobei mindestens einige der piezoelektrischen Elemente (14) eine Gestalt aufweisen, die in einer Richtung, die sich quer zu der Vorschubrichtung der Fahrzeuge erstreckt, verlängert ist.

6. System (10) zur Stromerzeugung nach den Ansprüchen 4 und 5, wobei mindestens einige der piezoelektrischen Elemente (14) sich quer von einem der zwei gegenüberliegenden seitlichen Enden (20a oder 20b) des Fahrspurbereichs (20) mit stromerzeugenden Platten zu einer Mittellinie desselben Fahrspurbereichs erstrecken.

## Revendications

1. Un système (10) de production de courant électrique, comprenant une chaussée (22) avec :
au moins une section de voie de production d'énergie (20) ayant un revêtement routier qui intègre une pluralité de panneaux générateurs de courant électrique (12) comprenant une pluralité d'éléments piézoélectriques (14) compressibles et orientés dans une direction donnée, configurés pour être comprimés et générer en conséquence un courant électrique en raison du déplacement d'un véhicule, **caractérisé par** au moins une section de voie (18) pour le transfert d'énergie sans fil dynamique avec des bobines de transmission de puissance (16) électriquement connectées auxdits panneaux (12) d'éléments piézoélectriques de production d'énergie (14) et étant configurées pour recharger électriquement un véhicule électrique circulant sur la section de voie (18) pour le transfert d'énergie sans fil dynamique.

2. Un système (10) de production de courant électrique selon la revendication 1, dans lequel la section de voie (18) pour le transfert d'énergie sans fil dynamique est parallèle et adjacente à la section de voie de production d'énergie (20) ayant les panneaux générateurs de courant électrique (12).

3. Un système (10) de production de courant électrique selon la revendication 1, dans lequel les sections de voie (18) pour le transfert d'énergie sans fil dynamique sont intercalées avec et alignées longitudinalement avec les sections de voie de production d'énergie (20) ayant les panneaux générateurs de courant électrique (12).

4. Un système (10) de production de courant électrique selon l'une quelconque des revendications 1 à 3, dans lequel au moins certains des éléments piézoélectriques (14) sont disposés vers les extrémités latérales (20a et 20b) de la section de voie (20) ayant les panneaux générateurs de courant électrique (12).

5. Un système (10) de production de courant électrique selon l'une quelconque des revendications précédentes, dans lequel au moins certains des éléments piézoélectriques (14) ont une forme allongée dans une direction transversale par rapport à la direction d'avancement des véhicules.

6. Un système (10) de production de courant électrique selon les revendications 4 et 5, dans lequel au moins certains des éléments piézoélectriques (14) s'étendent transversalement depuis l'une des deux extrémités latérales opposées (20a ou 20b) de la section de voie (20) avec des panneaux de production d'énergie vers une ligne médiane de ladite section de voie.
